# EUROPEAN PATENT APPLICATION

(11) **EP 4 822 747 A1**
(43) Date of publication of application: **14.10.2026**
(21) Application number: 24801809.5
(22) Date of filing: 23.02.2024
(51) Int. Cl.: H01L 23/552, H01L 25/065, H01L 25/07, H01L 23/14, H02M 1/44, H02M 1/00, H03K 17/687

(54) **PLANAR DEVICE AND SWITCHING FUNCTION CIRCUIT**

(30) Priority: 04.12.2023 CN 202311686472
(71) Applicant: Sungrow Power Supply Co., Ltd., Hefei, Anhui 230088 (CN)
(72) Inventor: ZHUANG, Jiacai, Hefei, Anhui 230088 (CN); WANG, Tengfei, Hefei, Anhui 230088 (CN)
(74) Representative: Zacco Norway AS
(86) International application number: PCT/CN2024/078339
(87) International publication number: WO 2025/118410

(57) **Abstract**

The present disclosure relates to the technical field of power electronics, and discloses a planar device and a switching circuit, for shielding a high-frequency jumping potential on the chip in the planar device, and reducing electromagnetic interference caused by the high-frequency jumping potential on the chip. The planar device includes at least one chip and a base; where the chip includes a substrate; the substrate is arranged on a side of the chip close to the base, and the substrate is electrically connected to the base; a side of the chip away from the base is provided with at least one source and at least one gate; the at least one source and the at least one gate are electrically connected to the chip; and the base is connected to a target potential point, and the target potential point is for maintaining a potential of the base in a low-frequency changing state or a constant state.

## Description

This application claims priority to Chinese Patent Application No. 202311686472.2 titled "PLANAR DEVICE AND SWITCHING CIRCUIT", filed on December 4, 2023 with the China National Intellectual Property Administration (CNIPA), which is incorporated herein by reference in its entirety.

### FIELD

The present disclosure relates to the technical field of power electronics, and in particular to a planar device and a switching circuit.

### BACKGROUND

Planar devices, especially those represented by GaN, have great application prospects in power electronic devices. A chip (such as a unidirectional chip or a bidirectional chip) in a conventional planar device is in contact with a heat sink through an insulating medium. A potential of the chip jumps at a high frequency. There is a parasitic capacitor between the chip and the heat sink, and thus the high-frequency jumping potential of the chip generates a current flowing between the chip and the heat sink through the parasitic capacitor, resulting in a problem of electromagnetic interference.

### SUMMARY

A planar device and a switching circuit are provided according to the present disclosure, to shield a high-frequency jumping potential on the chip in the planar device, and to reduce the electromagnetic interference caused by the high-frequency jumping potential on the chip.

In a first aspect of the embodiments of the present disclosure, a planar device is provided. The planar device includes: at least one chip and a base. For each of the at least one chip, the chip includes a substrate; the substrate is arranged on a side of the chip close to the base, and the substrate is electrically connected to the base; a side of the chip away from the base is provided with at least one source and at least one gate; the at least one source and the at least one gate are electrically connected to the chip; and the base is connected to a target potential point, and the target potential point is for maintaining a potential of the base in a low-frequency changing state.

In an embodiment of the first aspect, the base is electrically connected to a drain or one of the at least one source, and the drain or the one of the at least one source is the same as the base in potential.

In an embodiment of the first aspect, the base is a copper base or a direct bond copper ceramic base with copper on one side.

In an embodiment of the first aspect, the target potential point is a static potential point or a low-frequency potential point.

In an embodiment of the first aspect, the target potential point is an alternating-current phase voltage potential point, an alternating-current line voltage potential point, or a direct-current bus voltage potential point.

In an embodiment of the first aspect, the at least one chip is a planar single-transistor chip; and a side of the planar single-transistor chip away from the base is provided with one source, one gate, and one drain.

In an embodiment the first aspect, the at least one chip is a half-bridge unidirectional chip; and the planar device further includes a half-bridge midpoint. A side of the half-bridge unidirectional chip away from the base is provided with a first source, a first drain, a first gate and a second gate; and the first source, the first drain, the first gate, the second gate and the half-bridge midpoint are connected to the half-bridge unidirectional chip.

In an embodiment of the first aspect, the at least one chip is a planar bidirectional chip; a side of the planar bidirectional chip away from the base is provided with a first source, a second source, a first gate, and a second gate; and the first source, the second source, the first gate and the second gate are connected to the planar bidirectional chip.

In an embodiment of the first aspect, the at least one chip includes a first planar bidirectional chip and a second planar bidirectional chip; the planar device further includes a half-bridge midpoint; a side of the first planar bidirectional chip away from the base is provided with a first source, a first gate and a second gate; a side of the second planar bidirectional chip away from the base is provided with a second source, a third gate, and a fourth gate; and the first source, the first gate and the second gate are connected to a first side of the first planar bidirectional chip; the second source, the third gate and the fourth gate are connected to a first side of the second planar bidirectional chip; a second side of the first planar bidirectional chip is connected to a second side of the second planar bidirectional chip, and a connection point of the second side of the first planar bidirectional chip and the second side of the second planar bidirectional chip is connected to the half-bridge midpoint.

In a second aspect of the embodiments of the present disclosure, a switching circuit is provided. The switching circuit includes: the at least two planar devices as described in the embodiments of the first aspect and a direct-current bus; where the at least two planar devices include: a first planar device located on an upper transistor of a first bridge arm and a second planar device located on a lower transistor of the first bridge arm; a drain of the first planar device is connected to a positive electrode of the direct-current bus; a source of the second planar device is connected to a negative electrode of the direct-current bus; and a source of the first planar device is connected to a drain of the second planar device.

In an embodiment of the second aspect, the at least two planar devices further include a third planar device located on an upper transistor of a second bridge arm and a fourth planar device located on a lower transistor of the second bridge arm; a drain of the third planar device is connected to the positive electrode of the direct-current bus; a source of the fourth planar device is connected to the negative electrode of the direct-current bus; and a source of the third planar device is connected to a drain of the fourth planar device.

In a third aspect of the embodiments of the present disclosure, a switching circuit is provided. The switching circuit includes: the at least one planar device as described in the embodiments of the first aspect and a direct-current bus; where a drain of each of the at least one planar device is connected to a positive electrode of the direct-current bus; and a source of each of the at least one planar device is connected to a negative electrode of the direct-current bus.

In a fourth aspect of the embodiments of the present disclosure, a switching circuit is provided. The switching circuit includes the at least two planar devices as described in the embodiments of the first aspect and a filter unit; where the filter unit includes at least one capacitor; the at least two planar devices include a first planar device located on an upper transistor of a first bridge arm and a second planar device located on a lower transistor of the first bridge arm; a first source of the first planar device is connected to a first terminal of the filter unit and a terminal of two lines of single-phase alternating-current power; a first source of the second planar device is connected to a second terminal of the filter unit and another terminal of the two lines of the single-phase alternating-current power; and a second source of the first planar device is connected to a second source of the second planar device.

In an embodiment of the fourth aspect, the at least two planar devices further include a third planar device located on an upper transistor of a second bridge arm and a fourth planar device located on a lower transistor of the second bridge arm; a first source of the third planar device is connected to the first terminal of the filter unit and a terminal of the two lines of the single-phase alternating-current power; a first source of the fourth planar device is connected to the second terminal of the filter unit and another terminal of the two lines of the single-phase alternating-current power; and a second source of the third planar device is connected to a second source of the fourth planar device.

In a fifth aspect of the embodiments of the present disclosure, a switching circuit is provided. The switching circuit includes: the three planar devices as described in the embodiments of the first aspect, a first impedance, a second impedance, a third impedance, a first capacitor, a second capacitor and a third capacitor; where the three planar devices include a first planar device located on a first bridge arm, a second planar device located on a second bridge arm and a third planar device located on a third bridge arm; a first alternating-current phase line is connected to a second source of the first planar device and a first terminal of the first capacitor through the first impedance; a second alternating-current phase line is connected to a second source of the second planar device and a first terminal of the second capacitor through the second impedance; a third alternating-current phase line is connected to a second source of the third planar device and a first terminal of the third capacitor through the third impedance; a first source of the first planar device, a first source of the second planar device, and a first source of the third planar device are connected to each other; and a second terminal of the first capacitor, a second terminal of the second capacitor, and a second terminal of the third capacitor are connected to each other.

In a sixth aspect of the embodiments of the present disclosure, a switching circuit is provided. The switching circuit includes: the six planar devices as described in the embodiments of the first aspect, a first impedance, a second impedance, a third impedance, a first capacitor, a second capacitor and a third capacitor; where the six planar devices include a first planar device located on an upper transistor of a first bridge arm, a second planar device located on an upper transistor of a second bridge arm, a third planar device located on an upper transistor of a third bridge arm, a fourth planar device located on a lower transistor of the first bridge arm, a fifth planar device located on a lower transistor of the second bridge arm, and a sixth planar device located on a lower transistor of the third bridge arm; a first alternating-current phase line is connected to a second source of the fourth planar device and a second source of the first planar device through the first impedance; a second alternating-current phase line is connected to a second source of the fifth planar device and a second source of the second planar device; a third alternating-current phase line is connected to a second source of the sixth planar device and a second source of the third planar device through the third impedance; a first source of the first planar device, a first source of the second planar device, and a first source of the third planar device are connected to each other; a first source of the fourth planar device, a first source of the fifth planar device, and a first source of the sixth planar device are connected to each other; and a first terminal of the first capacitor is connected to the first alternating-current phase line, a first terminal of the second capacitor is connected to the second alternating-current phase line, and a first terminal of the third capacitor is connected to the third alternating-current phase line; and a second terminal of the first capacitor, a second terminal of the second capacitor, and a second terminal of the third capacitor are connected to each other.

In a seventh aspect of the embodiments of the present disclosure, a switching circuit is provided. The switching circuit includes the at least one planar device as described in the embodiments of the first aspect and a filter unit; where the filter unit includes at least one capacitor; a first source of each of the at least one planar device is connected to a first terminal of the filter unit and a terminal of two lines of single-phase alternating-current power; and a second source of each of the at least one planar device is connected to a second terminal of the filter unit and another terminal of the two lines of single-phase alternating-current power.

In the technical solution according to the embodiments of the present disclosure, the planar device includes at least one chip and a base. For each of the at least one chip, the chip includes a substrate; the substrate is arranged on a side of the chip close to the base, and the substrate is electrically connected to the base; a side of the chip away from the base is provided with at least one source and at least one gate; the at least one source and the at least one gate are electrically connected to the chip; and the base is connected to a target potential point, and the target potential point is for maintaining a potential of the base in a low-frequency changing state or a constant state. According to the embodiments of the present disclosure, the base in the planar device is connected to the target potential point, shielding the high-frequency change in potential on the chip in the planar device, and reducing electromagnetic interference of the chip to a heat sink.

### BRIEF DESCRIPTION OF THE DRAWINGS

FIG. 1 is a schematic diagram of parasitic capacitors in a planar device;
FIG. 2 is a schematic diagram of a planar device according to an embodiment of the present disclosure;
FIG. 3 is a schematic diagram of a planar device according to another embodiment of the present disclosure;
FIG. 4 is a schematic diagram of a planar device according to another embodiment of the present disclosure;
FIG. 5 is a schematic diagram of a planar device according to another embodiment of the present disclosure;
FIG. 6 is a schematic diagram of a planar device according to another embodiment of the present disclosure;
FIG. 7 illustrates equivalent circuit symbols corresponding to a planar device including a planar single-transistor chip according to an embodiment of the present disclosure;
FIG. 8 is a schematic diagram of a planar device according to another embodiment of the present disclosure;
FIG. 9 is a schematic diagram of a planar device according to another embodiment of the present disclosure;
FIG. 10 illustrates equivalent circuit symbols corresponding to a planar device including a half-bridge unidirectional chip according to an embodiment of the present disclosure;
FIG. 11 is a schematic diagram of a bidirectional switching device formed by a combination of unidirectional transistors;
FIG. 12 is a schematic diagram of a planar device according to another embodiment of the present disclosure;
FIG. 13 is a schematic diagram of a planar device according to another embodiment of the present disclosure;
FIG. 14 illustrates equivalent circuit symbols corresponding to a planar device including a planar bidirectional chip according to an embodiment of the present disclosure;
FIG. 15 is a schematic diagram of a planar device according to another embodiment of the present disclosure;
FIG. 16 is a schematic diagram of a planar device according to another embodiment of the present disclosure;
FIG. 17 illustrates equivalent circuit symbols corresponding to a planar device including two planar bidirectional chips according to an embodiment of the present disclosure;
FIG. 18 is a schematic diagram showing a planar device is in contact with a heat sink according to an embodiment of the present disclosure;
FIG. 19 is a schematic diagram showing a planar device is in contact with a heat sink according to another embodiment of the present disclosure;
FIG. 20 is a schematic diagram of application of a planar device including a planar single-transistor chip in a single-phase half-bridge circuit according to an embodiment of the present disclosure;
FIG. 21 is a schematic diagram of application of a planar device including a half-bridge unidirectional chip in a single-phase half-bridge circuit according to an embodiment of the present disclosure;
FIG. 22 is a schematic diagram of application of a planar device including a planar bidirectional chip in a single-phase half-bridge circuit according to an embodiment of the present disclosure;
FIG. 23 is a schematic diagram of application of a planar device including a planar bidirectional chip in a single-phase full-bridge circuit according to an embodiment of the present disclosure;
FIG. 24 is a schematic diagram of application of a planar device including a planar bidirectional chip in a three-phase half-controlled bridge circuit according to an embodiment of the present disclosure;
FIG. 25 is a schematic diagram of application of a planar device including a planar bidirectional chip in a three-phase fully controlled bridge circuit according to an embodiment of the present disclosure; and
FIG. 26 is a schematic diagram of application of a planar device including two planar bidirectional chips in a single-phase full-bridge circuit according to an embodiment of the present disclosure.

### DETAILED DESCRIPTION

A planar device and a switching circuit are provided according to the present disclosure, to shield a high-frequency jumping potential on the chip in the planar device, and to reduce the electromagnetic interference caused by the high-frequency jumping potential on the chip.

The terms such as "first", "second", "third", "fourth" and the like (if any) in the description, claims and drawings are only used to distinguish similar objects from each other, rather than describe a particular or chronological order. It should be understood that data used in such manner may be interchanged appropriately, so that the embodiments of the present disclosure may be, for example, implemented in an order other than those illustrated or described herein. Moreover, the terms "include (comprise)", "have", and any other variants thereof are intended to cover a non-exclusive inclusion. For example, a process, method, system, product, or apparatus that includes a list of steps or units is not necessarily limited to the expressly listed steps or units, but may include other steps or units not expressly listed or inherent to the process, method, product, or apparatus.

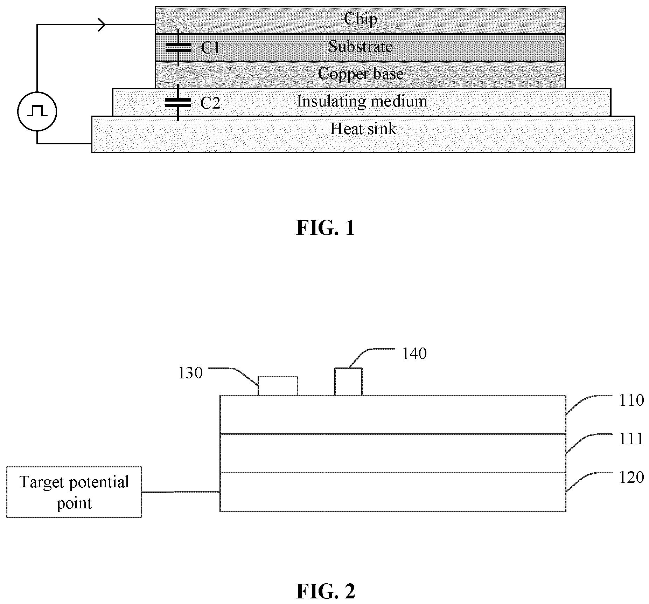

In a case where a conventional planar switching device externally provided with a heat sink is applied in a circuit, a potential on a chip in the switching device jumps at a high frequency. As shown in FIG. 1, there is a parasitic capacitor C1 between the chip and a copper base (i.e., a base), and a parasitic capacitor C2 between the copper base and a heat sink. During a high-frequency switching by the chip in the circuit, a potential changes at a high frequency. The high-frequency jumping potential of the chip generates a current flowing between the chip and the heat sink through a parasitic capacitor. Hence, a high-frequency changing current exists on the parasitic capacitor, resulting in a problem of electromagnetic interference.

In order to solve the problem of electromagnetic interference, a planar device is provided according to an embodiment of the present disclosure. Referring to FIG. 2, the planar device includes: at least one chip 110 and a base 120. Each of the at least one chip 110 includes a substrate 111. The substrate 111 is arranged on a side of the chip 110 close to the base 120, and the substrate 111 is electrically connected to the base 120. A side of the chip 110 away from the base 120 is provided with at least one source 130 and at least one gate 140. The at least one source 130 and the at least one gate 140 are electrically connected to the chip 110. The base 120 is connected to a target potential point, and the target potential point is for maintaining a potential of the base 120 in a low-frequency changing state.

The chip in the planar device may be a gallium nitride (GaN) chip, such as a Cascade GaN chip or enhanced GaN chip, which is not limited herein.

In the planar device according to the present disclosure, the base in the planar device is connected to the target potential point with a potential changing at a low frequency, limiting the high-frequency current generated by the high-frequency change in potential in the chip to between the chip and the base. Hence, there is no high-frequency changing voltage between the base and the external heat sink, so that there is no high-frequency changing current flowing between the chip and the external heat sink through the parasitic capacitor, reducing the impact of electromagnetic interference.

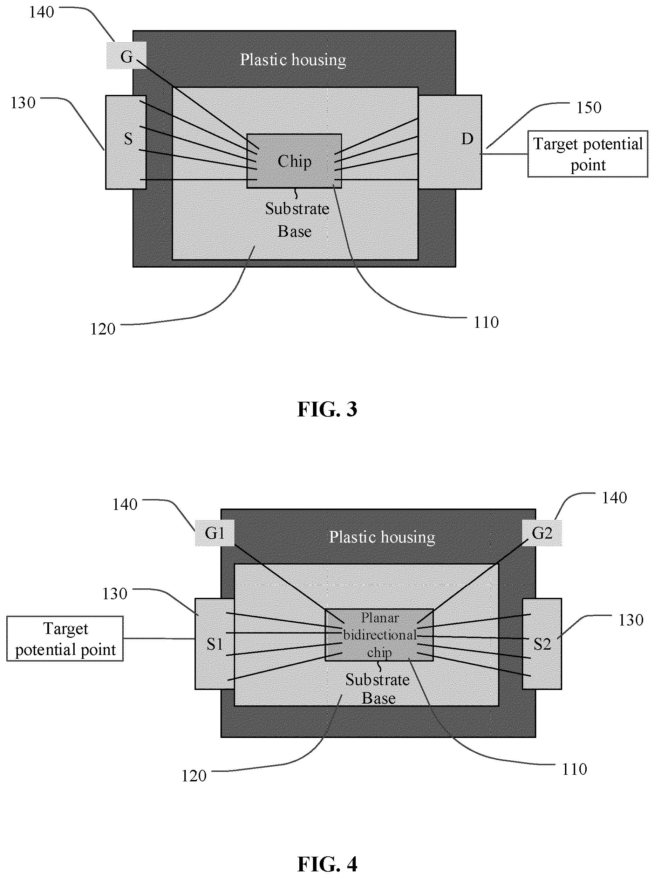

In an embodiment, the base 120 is electrically connected to a drain 150 or one of the at least one source 130, and the drain 150 or the one of the at least one source 130 is the same as the base 120 in potential. FIG. 3 illustrates a situation where the base 120 is connected to the drain 150.

The base 120 is connected to the drain 150 or one of the at least one source 130 inside the planar device.

As shown in FIG. 3, the drain 150 connected to the base 120 is connected to the target potential point. The drain 150 connected to the base 120 is the same as the target potential point in potential, and is maintained in a low-frequency change.

Reference is made to FIG. 3, which is a schematic structural diagram showing that the base 120 is electrically connected to the drain 150. In FIG. 3, S represents the source, connected to the chip 110. G represents the gate, connected to the chip 110. D represents the drain, connected to the chip 110. The drain D and the base 120 are electrically connected to each other. In this case, a potential of the drain D is also maintained in a low-frequency change, and the substrate 111 is located below the chip. FIG. 3 is only illustrative.

Reference is made to FIG. 4, which is a schematic structural diagram showing that the base 120 is electrically connected to a first source 130. In FIG. 4, S1 represents a first source and S2 represents a second source, both of which are connected to a planar bidirectional chip 110. G1 represents a first gate and G2 represents a second gate, both of which are connected to the planar bidirectional chip 110. The first source S1 and the base 120 are electrically connected to each other. In this case, a potential of the first source S1 is maintained in a low-frequency change, and the substrate 111 is located below the bidirectional chip. FIG. 4 is only illustrative.

In an embodiment, the base is a copper base or a direct bond copper ceramic base with copper on one side.

As shown in FIG. 3 or FIG. 4, the base 120 is a copper base or a direct bond copper (DBC) ceramic base with copper on one side. The copper base has a copper frame, and may be made of a single metal copper.

It may be understood that the base may be made of other material meeting the requirement, and the material is not limited here.

In an embodiment, the target potential point is a static potential point or a low-frequency potential point.

The potential of the target potential point changes at a low frequency or is unchanged relative to a potential of the heat sink.

In an embodiment, the target potential point is an alternating-current phase voltage potential point, an alternating-current line voltage potential point or a direct-current bus voltage potential point.

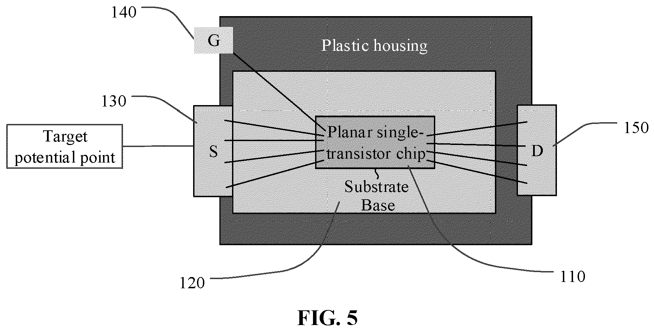

In an embodiment, as shown in FIG. 5, the at least one chip 110 is a planar single-transistor chip.

A side of the planar single-transistor chip 110 away from the base 120 is provided with one source 130, one gate 140, and one drain 150.

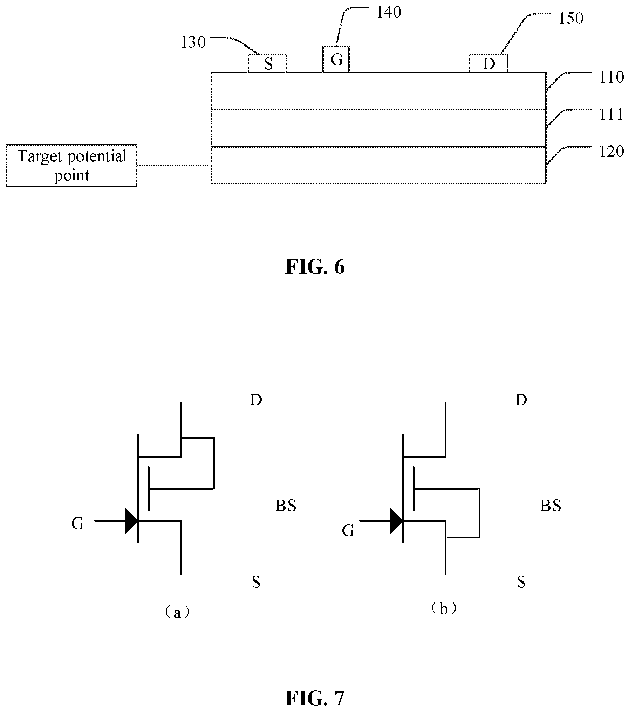

For example, as shown in FIG. 6, a side of the planar single-transistor chip 110 away from the base 120 is provided with one source 130, one gate 140, and one drain 150.

FIG. 7 illustrates equivalent circuit symbols corresponding to a planar device provided with a planar single-transistor chip, where G represents the gate, S represents the source, D represents the drain, and BS represents the base. FIG. 7(a) illustrates the equivalent circuit symbols in a case where the base 120 is connected to the drain inside the planar device. FIG. 7(b) illustrates the equivalent circuit symbols in a case where the base 120 is connected to the source inside the planar device.

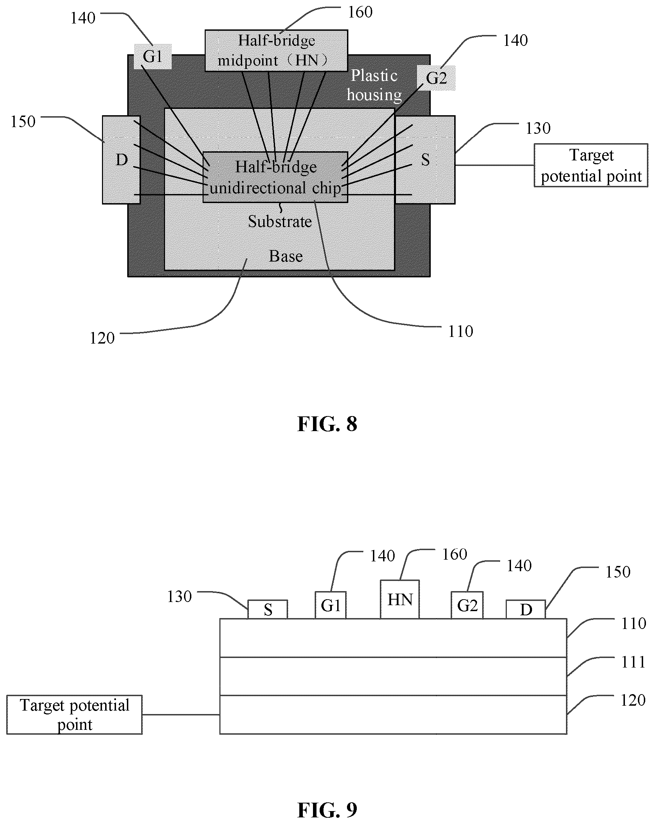

In an embodiment, as shown in FIG. 8, the at least one chip 110 is a half-bridge unidirectional chip, and the planar device further includes a half-bridge midpoint 160.

As shown in FIG. 9, a side of the half-bridge unidirectional chip 110 away from the base 120 is provided with a first source 130 (S1), a first drain 150 (D1), a first gate 140 (G1) and a second gate 140 (G2).

The first source 130 (S1), the first drain 150 (D1), the first gate 140 (G1), the second gate 140 (G2) and the half-bridge midpoint 160 (HN) are connected to the half-bridge unidirectional chip.

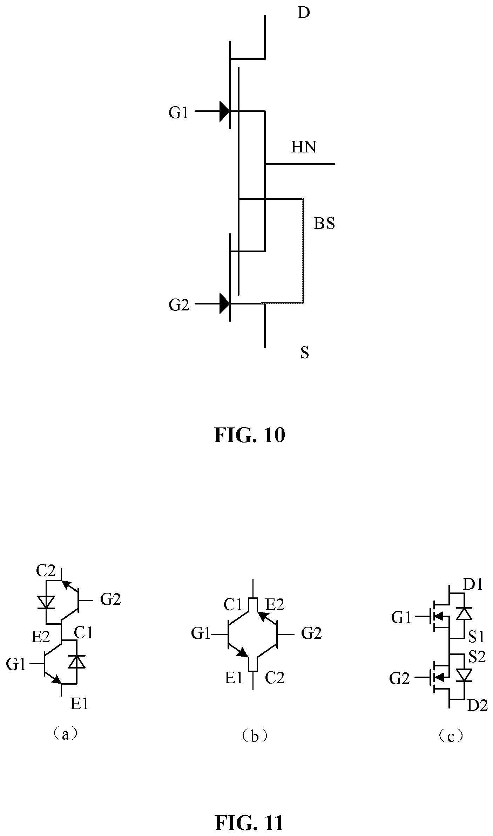

FIG. 10 illustrates equivalent circuit symbols corresponding to a planar device provided with a half-bridge unidirectional chip, where G1 represents a first gate, G2 represents a second gate, S represents a source, D represents a drain, BS represents a base, and HN represents a half-bridge midpoint.

In the embodiment of the present disclosure, two planar single-transistor chips are grown on a same substrate to form a half-bridge unidirectional chip, the two planar single-transistor chips are electrically connected to each other, and a connection point of the two planar single-transistor chips is connected to the half-bridge midpoint. The base is connected to a low-frequency potential point, shielding a high-frequency change in potential on the chip, reducing the electromagnetic interference of each planar single-transistor chip to the heat sink, thereby improving the integration of the application circuit.

It should be noted that the combination of two unidirectional transistors fails to implement a maximum performance of a bidirectional switch. For example, as shown in FIG. 11(a), a bidirectional switching function is implemented through two insulated gate bipolar transistors (IGBT). In a case where the IGBT has an anti-parallel diode, two IGBTs are connected in serial to implement the bidirectional switching function. A first IGBT has a gate G1, an emitter E1 and a collector C1. A second IGBT has a gate G2, an emitter E2 and a collector C2. The emitter E2 of the second IGBT is connected to the collector C1 of the first IGBT, implementing the bidirectional switch. Alternatively, as shown in FIG. 11(b), the IGBT has no anti-parallel diode, two IGBTs are connected in parallel to implement the bidirectional switching function. A first IGBT has a gate G1, an emitter E1 and a collector C1, and a second IGBT has a gate G2, an emitter E2 and a collector C2. The emitter E1 of the first IGBT is connected to the collector C2 of the second IGBT, and the emitter E2 of the second IGBT is connected to the collector C1 of the first IGBT, implementing the bidirectional switch. Alternatively, the bidirectional switching function may be implemented through two enhanced metal oxide semiconductor field effect transistors (MOSFET), referred to as a MOS transistor. As shown in FIG. 11(c), the bidirectional switching function is implemented through two N-channel enhanced MOS transistors. A first N-channel enhanced MOS transistor has a gate G1, a source S1 and a drain D1. A second N-channel enhanced MOS transistor has a gate G2, a source S2 and a drain D2. The source S1 of the first N-channel enhanced MOS transistor is connected to the source S2 of the second N-channel enhanced MOS transistor, implementing the bidirectional switch. Compared with the solution of a combination of two unidirectional transistors to implement the bidirectional switch, a planar bidirectional chip is provided according to the embodiments of the present disclosure. In the planar bidirectional chip, two planar single-transistor chips are integrated on a same substrate to implement a bidirectional on/off function, and the planar device having the planar bidirectional chip has a smaller size, lower cost, and a smaller parasitic parameter compared with a combination of two planar devices (each of which is provided with a planar single-transistor chip, such as a GaN chip).

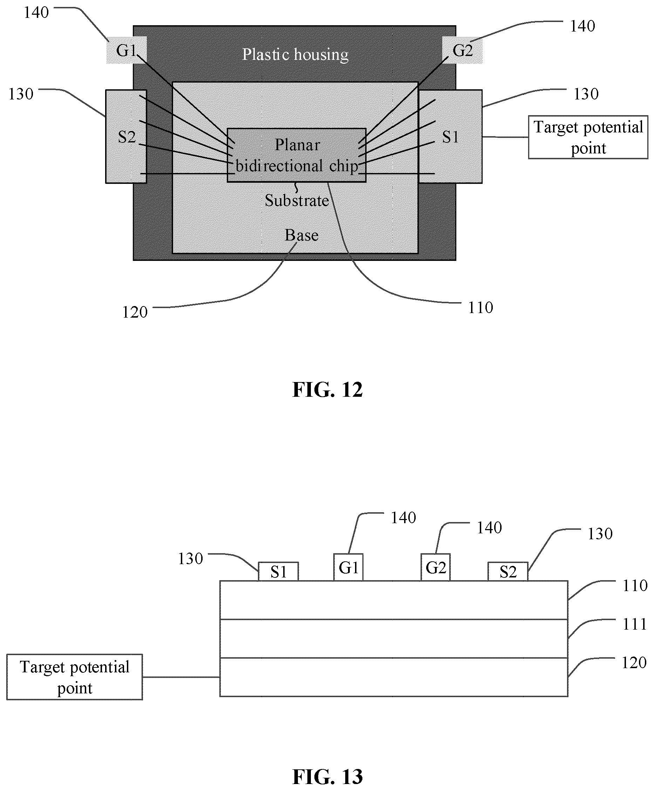

In an embodiment, as shown in FIG. 12, the at least one chip 110 is a planar bidirectional chip.

A side of the planar bidirectional chip away from the base 120 is provided with a first source 130, a second source 130, a first gate 140, and a second gate 140.

The first source 130 (S1), the second source 130 (S2), the first gate 140 (G1) and the second gate 140 (G2) are connected to the planar bidirectional chip.

As shown in FIG. 13, a side of the planar bidirectional chip away from the base 120 is provided with a first source S1, a second source S2, a first gate G1, and a second gate G2.

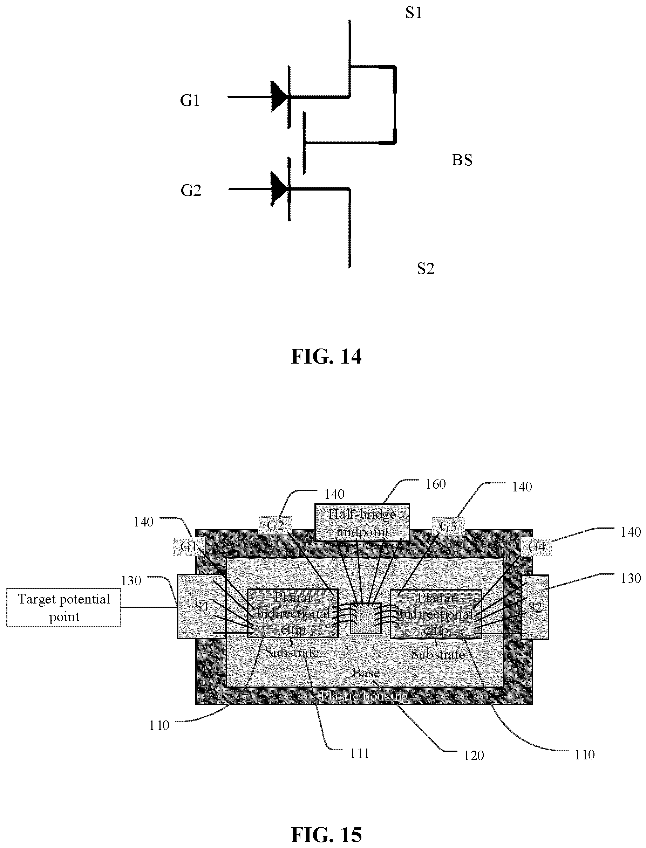

The first source S1, the second source S2, the first gate G1 and the second gate G2 are connected to the planar bidirectional chip. FIG. 14 illustrates equivalent circuit symbols corresponding to a planar device provided with a planar bidirectional chip, where G1 represents a first gate, G2 represents a second gate, S1 represents a first source, S2 represents a second source, and BS represents a base.

In an embodiment, as shown in FIG. 15, the at least one chip includes a first planar bidirectional chip and a second planar bidirectional chip. The planar device further includes a half-bridge midpoint 160.

A side of the first planar bidirectional chip away from the base 120 is provided with a first source 130 (S1), a first gate 140 (G1), and a second gate 140 (G2).

A side of the second planar bidirectional chip away from the base 120 is provided with a second source 130 (S2), a third gate 140 (G3), and a fourth gate 140 (G4).

The first source S1, the first gate G1 and the second gate G2 are connected to a first side of the first planar bidirectional chip. The second source S2, the third gate G3 and the fourth gate G4 are connected to a first side of the second planar bidirectional chip. A second side of the first planar bidirectional chip is connected to a second side of the second planar bidirectional chip, and a connection point of the both second sides is connected to the half-bridge midpoint 160.

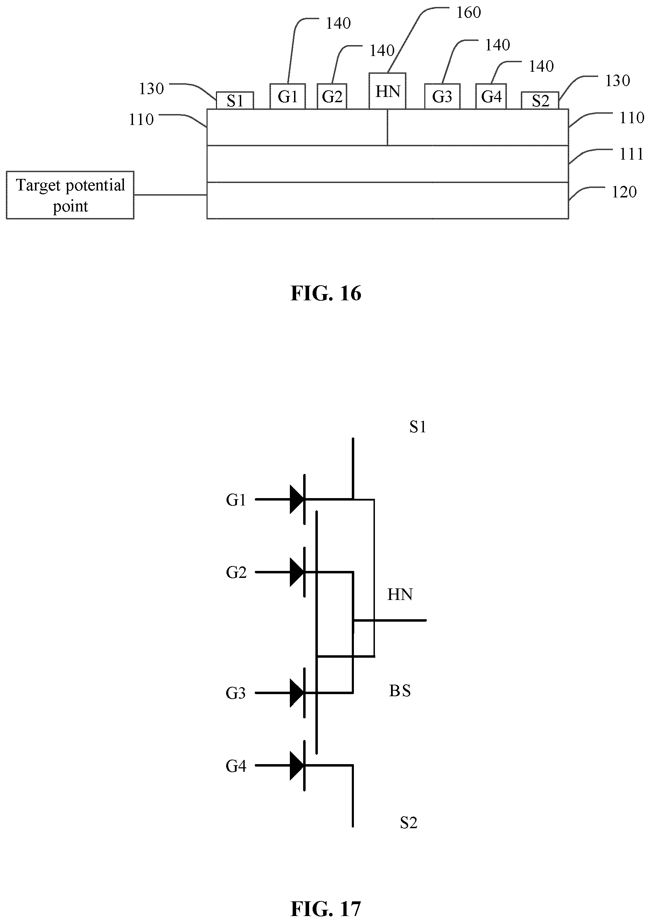

As shown in FIG. 16, a side of the first planar bidirectional chip away from the base 120 is provided with a first source S1, a first gate G1, and a second gate G2.

A side of the second planar bidirectional chip away from the base 120 is provided with a second source S2, a third gate G3, and a fourth gate G4.

The first source S1, the first gate G1 and the second gate G2 are connected to a first side of the first planar bidirectional chip. The second source S2, the third gate G3 and the fourth gate G4 are connected to a first side of the second planar bidirectional chip. A second side of the first planar bidirectional chip is connected to a second side of the second planar bidirectional chip, and a connection point of the both second sides is connected to the half-bridge midpoint 160.

FIG. 17 illustrates equivalent circuit symbols corresponding to a planar device provided with two planar bidirectional chips, where G1 represents a first gate, G2 represents a second gate, G3 represents a third gate, G4 represents a fourth gate, S1 represents a first source, S2 represents a second source, BS represents a base, and HN represents a half-bridge midpoint.

In an embodiment of the present disclosure, two planar bidirectional chips are grown on two respective substrates, the two planar bidirectional chips are electrically connected to each other, and the connection point of the two planar bidirectional chips is connected to the half-bridge midpoint. The base is connected to a low-frequency potential point or static potential point, shielding a high-frequency change in potential on the chip, reducing the electromagnetic interference of each planar bidirectional chip to the heat sink, thereby improving the integration of the application circuit.

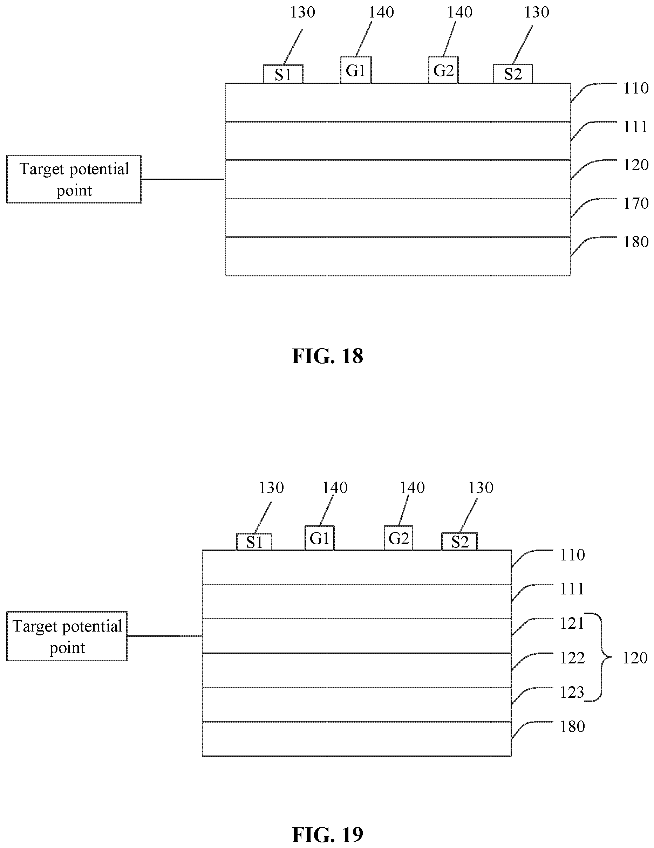

It should be noted that in an actual application, the planar device according to any of the above embodiments is cooled by an insulating medium 170 and a heat sink 180. For example, as shown in FIG. 18, the insulating medium 170 is arranged between the base 120 and the heat sink 180. That is, the insulating medium 170 is arranged below the base 120, and the heat sink 180 is arranged below the insulating medium 170.

In the embodiment, the base 120 is connected to the target potential point where the potential changes at a low frequency or is unchanged, so that the high-frequency current generated by the high-frequency change in potential on the chip 110 only flows between the chip and the base 120. Hence, there is no high-frequency changing voltage between the base 120 and the heat sink 180, so that no high-frequency changing current flows between the base 120 and the heat sink 180 through a parasitic capacitor, eliminating or reducing the impact of electromagnetic interference.

It should be noted that in a case where the base 120 is implemented by a DBC with copper 121 on one side, a ceramic plate 122 in the DBC is for insulation, and copper on the other side of the DBC is for heat dissipation, forming a heat dissipation copper base 123, as shown in FIG. 19.

The ceramic plate 122 is arranged in the middle of the DBC, and the two sides of the DBC are made of metal copper. That is, in the DBC base, the DBC with copper 121 on one side, the ceramic plate 122 and the heat dissipation copper base 123 can achieve functions of both insulation and heat dissipation. In a case where the base 120 is implemented by the DBC base, the DBC base is directly in contact with the heat sink 180, rather than being in contact with the heat sink 180 through the insulating medium 170.

According to the embodiments of the present disclosure, the base in the planar device is connected to the target potential point, shielding the high-frequency change in potential on the chip in the planar device, and reducing electromagnetic interference of the chip to the heat sink.

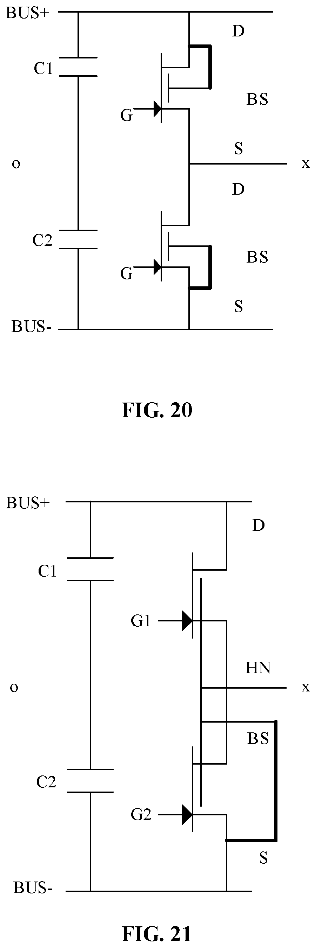

Referring to FIG. 20 to FIG. 26, different planar devices are connected to each other in different manners in a circuit. The bidirectional switch is implemented in different manners for different circuits. For example, a single-phase half-bridge circuit, a single-phase full-bridge circuit and a three-phase bridge circuit are implemented by the planar devices shown in FIG. 7, FIG. 10, FIG. 14 or FIG. 17 in different connection manners.

A switching circuit is provided according to an embodiment of the present disclosure. The planar device in the switching circuit is implemented by the planar single-transistor chip as shown in FIG. 8. The switching circuit includes: at least two planar devices and a direct-current bus. The at least two planar devices include: a first planar device located on an upper transistor of a first bridge arm and a second planar device located on a lower transistor of the first bridge arm. A drain of the first planar device is connected to a positive electrode of the direct-current bus. A source of the second planar device is connected to a negative electrode of the direct-current bus. A source of the first planar device is connected to a drain of the second planar device.

For example, in a case where the single-phase half-bridge circuit is implemented by the planar device shown in FIG. 7 (that is, the planar device is provided with the planar single-transistor chip), an internal base of one planar device is connected to the drain of the planar device, and an internal base of the other planar device is connected to the source of the planar device, corresponding to the circuit shown in FIG. 20. In the two planar devices, a source and a drain that are connected to neither a positive electrode BUS+ or a negative electrode BUS- of the direct-current bus are connected to each other, and a potential point x is led out by the connection point of the source and the drain. The positive electrode BUS+ of the direct-current bus is connected to the drain D of the first planar device in the upper transistor of the first bridge arm, and the negative electrode BUS- of the direct-current bus is connected to the source S of the second planar device in the lower transistor of the first bridge arm. The direct-current bus is formed by a first capacitor C1 and a second capacitor C2 between the positive electrode BUS+ and the negative electrode BUS- of the direct-current bus. The base BS of the first planar device is connected to the drain D of the first planar device. The base of the second planar device is connected to the source S of the second planar device. Here, the potential point x changes at a high frequency in potential, and a potential point o is unchanged in potential.

Alternatively, in a case where the single-phase full-bridge circuit is implemented by the planar device shown in FIG. 7, the at least two planar devices further include a third planar device located on an upper transistor of a second bridge arm and a fourth planar device located on a lower transistor of the second bridge arm. A drain of the third planar device is connected to the positive electrode of the direct-current bus; a source of the fourth planar device is connected to the negative electrode of the direct-current bus; and a source of the third planar device is connected to a drain of the fourth planar device.

A switching circuit is provided according to an embodiment of the present disclosure. A planar device is implemented by the half-bridge unidirectional chip as shown in FIG. 10. The switching circuit includes: at least one planar device and a direct-current bus. A drain of each planar device is connected to a positive electrode of the direct-current bus; and a source of each planar device is connected to a negative electrode of the direct-current bus.

For example, in a case where the single-phase half-bridge circuit is implemented by the planar device shown in FIG. 10 (that is, the planar device is provided with a half-bridge single-transistor chip), a corresponding circuit is shown in FIG. 21. A potential point x is led out by a half-bridge midpoint of the planar device. A positive electrode BUS+ of the direct-current bus is connected to a drain D of the planar device, and a negative electrode BUS- of the direct-current bus is connected to a source S of the planar device. The direct-current bus is formed by a first capacitor C1 and a second capacitor C2 between the positive electrode BUS+ and the negative electrode BUS- of the direct-current bus. A base BS of the planar device is electrically connected to the source S of the planar device inside the planar device. Here, the potential point x changes at a high frequency in potential, and the potential point o is unchanged in potential.

A switching circuit is provided according to an embodiment of the present disclosure. The planar device is implemented by the planar bidirectional chip as shown in FIG. 14. The switching circuit includes at least two planar devices and a filter unit. The filter unit includes at least one capacitor. The at least two planar devices include a first planar device located on an upper transistor of a first bridge arm and a second planar device located on a lower transistor of the first bridge arm. A first source of the first planar device is connected to a first terminal of the filter unit and a terminal of two lines of single-phase alternating-current power. A first source of the second planar device is connected to a second terminal of the filter unit and another terminal of the two lines of the single-phase alternating-current power. A second source of the first planar device is connected to a second source of the second planar device.

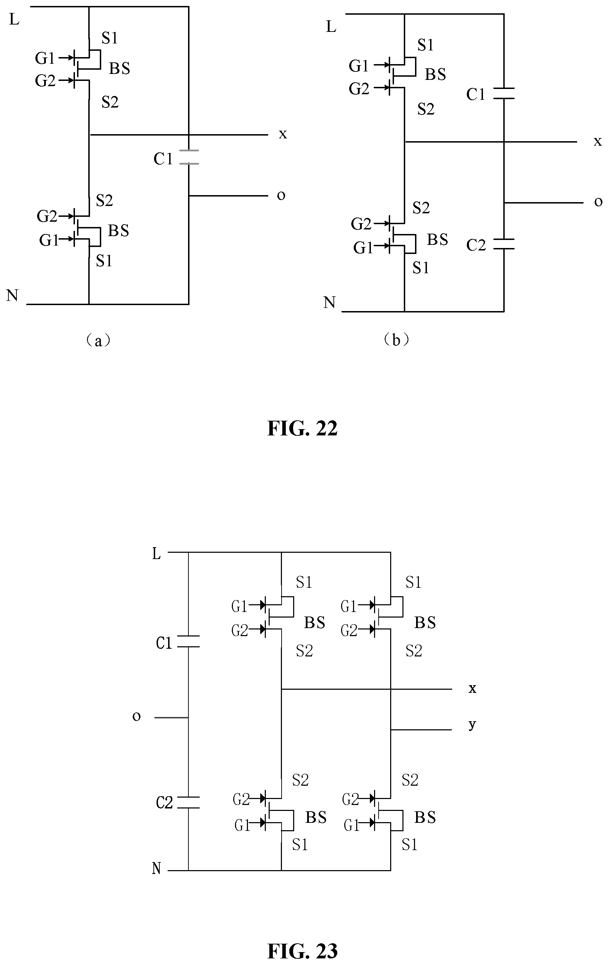

For example, in a case where the single-phase half-bridge circuit is implemented by the planar device shown in FIG. 14 (that is, the planar device is provided with the planar bidirectional chip), a corresponding circuit is shown in FIG. 22(a). In each planar device, the base BS is electrically connected to the first source S1 inside the planar device, and the first source S1 of the first planar device is connected to the first terminal of the filter unit and a terminal of two lines of single-phase alternating-current power. The first source S1 of the second planar device is connected to the second terminal of the filter unit and another terminal of the two lines of single-phase alternating-current power. The second source S2 of the first planar device is connected to the second source S2 of the second planar device, and a potential point x is led out by the connection point of both the second sources S2. The filter unit is formed by the first capacitor C1 between the two lines (i.e., a phase line L and a neutral line N) of the single-phase alternating-current power. A terminal of the first capacitor C1 is determined as a potential point o. Here, the potential point x changes at a high frequency in potential, and the potential point o changes at a low frequency with L/N alternating-current power in potential.

It can be understood that the filter unit may further include two or more capacitors. For example, the filter unit includes a first capacitor and a second capacitor. In this case, a first terminal of the first capacitor serves as a first terminal of the filter unit, and a first terminal of the second capacitor serves as a second terminal of the filter unit. A second terminal of the first capacitor is connected to a second terminal of the second capacitor.

For example, in a case where the single-phase half-bridge circuit is implemented by the planar device shown in FIG. 14 (that is, the planar device is provided with the planar bidirectional chip), a corresponding circuit is shown in FIG. 22(b). In each planar device, the base BS is electrically connected to the first source S1 inside the planar device, and the first source S1 of the first planar device is connected to the first terminal of the filter unit and a terminal of two lines of single-phase alternating-current power. The first source S1 of the second planar device is connected to the second terminal of the filter unit and another terminal of the two lines of single-phase alternating-current power. The second source S2 of the first planar device is connected to the second source S2 of the second planar device, and a potential point x is led out by the connection point of both the second sources S2. The filter unit is formed by the first capacitor C1 and the second capacitor C2 between the phase line L and the neutral line N. A midpoint between the first capacitor C1 and the second capacitor C2 is determined as a potential point o. Here, the potential point x changes at a high frequency in potential, and the potential point o changes at a low frequency with L/N alternating-current power in potential or is unchanged in potential.

A switching circuit is provided according to an embodiment of the present disclosure. The planar device is implemented by the planar bidirectional chip as shown in FIG. 14. Based on FIG. 22(b), the at least two planar devices further include a third planar device located on an upper transistor of a second bridge arm and a fourth planar device located on a lower transistor of the second bridge arm. A first source of the third planar device is connected to the first terminal of the filter unit and a terminal of two lines of single-phase alternating-current power. A first source of the fourth planar device is connected to the second terminal of the filter unit and another terminal of the two lines of single-phase alternating-current power. A second source of the third planar device is connected to a second source of the fourth planar device.

For example, in a case where the single-phase full-bridge circuit is implemented by the planar device shown in FIG. 14, a corresponding circuit is shown in FIG. 23. The circuit includes a first bridge arm and a second bridge arm. Second sources S2 of two planar devices (i.e., a first planar device and a third planar device) on the first bridge arm are connected to each other, and a potential point x is led out by a connection point of both the second sources S2. Second sources S2 of two planar devices (i.e., a second planar device and a fourth planar device) on the second bridge arm are connected to each other, and a potential point y is led out by a connection point of both the second sources S2. A terminal (i.e., a phase line L) of two lines of single-phase alternating-current power is connected to a first source S1 of the first planar device located in an upper transistor of the first bridge arm and a first source S1 of the third planar device located in an upper transistor of the second bridge arm. Another terminal (i.e., a neutral line N) of the two lines of the single-phase alternating-current power is connected to a first source S1 of the second planar device located in a lower transistor of the first bridge arm and a first source S1 of the fourth planar device located in a lower transistor of the second bridge arm. The filter unit is formed by the first capacitor C1 and the second capacitor C2 between the two lines (i.e., the phase line L and the neutral line N) of the single-phase alternating-current power. A midpoint between the first capacitor C1 and the second capacitor C2 is determined as a potential point o. For each of the planar devices, the base is electrically connected to the first source inside the planar device. Here, the potential point x/y changes at a high frequency in potential, and the potential point o changes at a low frequency with L/N alternating-current power in potential or is unchanged in potential.

A switching circuit is provided according to an embodiment of the present disclosure. The planar device is implemented by the planar bidirectional chip as shown in FIG. 14. The switching circuit includes: three planar devices, a first impedance, a second impedance, a third impedance, a first capacitor, a second capacitor and a third capacitor. The three planar devices include a first planar device located on a first bridge arm, a second planar device located on a second bridge arm and a third planar device located on a third bridge arm. A first alternating-current phase line is connected to a second source of the first planar device and a first terminal of the first capacitor through the first impedance. A second alternating-current phase line is connected to a second source of the second planar device and a first terminal of the second capacitor through the second impedance. A third alternating-current phase line is connected to a second source of the third planar device and a first terminal of the third capacitor through the third impedance. A first source of the first planar device, a first source of the second planar device and a first source of the third planar device are connected to each other. A second terminal of the first capacitor, a second terminal of the second capacitor and a second terminal of the third capacitor are connected to each other.

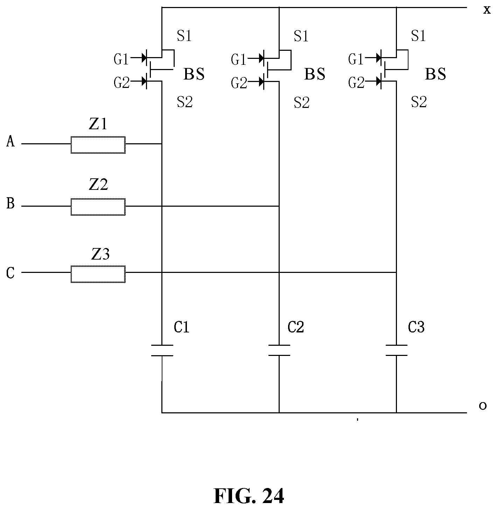

For example, in a case where a three-phase half-controlled bridge circuit is implemented by the planar device shown in FIG. 14, a corresponding circuit is shown in FIG. 24. The circuit includes a first bridge arm, a second bridge arm and a third bridge arm. A second source S2 of a first planar device on the first bridge arm is connected to the first terminal of the first capacitor C1, and a connection point of the second source S2 and the first terminal is connected to an A-phase alternating-current phase line (i.e., a first alternating-current phase line) through the first impedance Z1. A second source S2 of a second planar device on the second bridge arm is connected to the first terminal of the second capacitor C2, and a connection point of the second source S2 and the first terminal is connected to an B-phase alternating-current phase line (i.e., a second alternating-current phase line) through the second impedance Z2. A second source S2 of the third planar device on the third bridge arm is connected to the first terminal of the third capacitor C3, and a connection point of the second source S2 and the first terminal is connected to a C-phase alternating-current phase line (i.e., a third alternating-current phase line) through the third impedance Z3. The first sources S1 of the first planar device, the second planar device, and the third planar device are connected to each other, and a potential point x is led out by a connection point of the first sources S1. Second terminals of the first capacitor C1, the second capacitor C2, and the third capacitor C3 are connected to each other, and a potential point o is led out by a connection point of the second terminals. For each of the planar devices, the base is electrically connected to the first source inside the planar device. Here, the potential point x changes at a high frequency in potential, and the potential point o changes at a low frequency with the A/B/C alternating-current power in potential or is unchanged in potential.

A switching circuit is provided according to an embodiment of the present disclosure. The planar device is implemented by the planar bidirectional chip as shown in FIG. 14. The switching circuit includes: six planar devices, a first impedance, a second impedance, a third impedance, a first capacitor, a second capacitor and a third capacitor. The six planar devices include a first planar device located on an upper transistor of a first bridge arm, a second planar device located on an upper transistor of a second bridge arm, a third planar device located on an upper transistor of a third bridge arm, a fourth planar device located on a lower transistor of the first bridge arm, a fifth planar device located on a lower transistor of the second bridge arm, and a sixth planar device located on a lower transistor of the third bridge arm. A first alternating-current phase line is connected to a second source of the fourth planar device and a second source of the first planar device through the first impedance. A second alternating-current phase line is connected to a second source of the fifth planar device and a second source of the second planar device through the second impedance. A third alternating-current phase line is connected to a second source of the sixth planar device and a second source of the third planar device through the third impedance. A first source of the first planar device, a first source of the second planar device, and a first source of the third planar device are connected to each other. A first source of the fourth planar device, a first source of the fifth planar device, and a first source of the sixth planar device are connected to each other. A first terminal of the first capacitor is connected to the first alternating-current phase line, a first terminal of the second capacitor is connected to the second alternating-current phase line, and a first terminal of the third capacitor is connected to the third alternating-current phase line. A second terminal of the first capacitor, a second terminal of the second capacitor and a second terminal of the third capacitor are connected to each other.

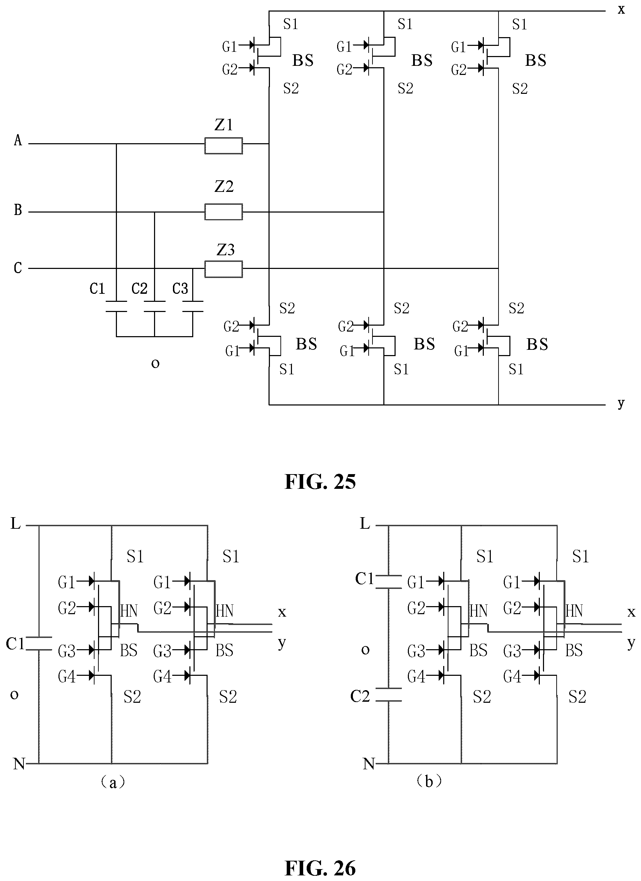

For example, in a case where a three-phase fully controlled bridge circuit is implemented by the planar device shown in FIG. 14, a corresponding circuit is shown in FIG. 25. The three-phase fully controlled bridge circuit includes a first bridge arm, a second bridge arm and a third bridge arm. Second sources S2 of two planar devices (i.e., a first planar device and a fourth planar device) on the first bridge arm are connected to each other, and a connection point of the second sources S2 is connected to an A-phase alternating-current phase line (i.e., a first alternating-current phase line) through the first impedance Z1. Second sources S2 of two planar devices (i.e., a second planar device and a fifth planar device) on the second bridge arm are connected to each other, and a connection point of the second sources S2 is connected to a B-phase alternating-current phase line (i.e., a second alternating-current phase line) through the second impedance Z2. Second sources S2 of two planar devices (i.e., a third planar device and a sixth planar device) on the third bridge arm are connected to each other, and a connection point of the second sources S2 is connected to a C-phase alternating-current phase line (i.e., a third alternating-current phase line) through the third impedance Z3. First sources S1 of the first planar device, the third planar device, and the fifth planar device are connected to each other, and a potential point x is led out by a connection point of the first sources S1. First sources S1 of the second planar device, the fourth planar device, and the sixth planar device are connected to each other, and a potential point y is led out by a connection point of the first sources S1. A first terminal of the first capacitor C1 is connected to the first alternating-current phase line (i.e., the A-phase alternating-current phase line), a first terminal of the second capacitor C2 is connected to the second alternating-current phase line (i.e., the B-phase alternating-current phase line), and a first terminal of the third capacitor C3 is connected to the third alternating-current phase line (i.e., the C-phase alternating-current phase line). A second terminal of the first capacitor C1, a second terminal of the second capacitor C2 and a second terminal of the third capacitor C3 are connected to each other at a common connection point o. For each of the planar devices, the base BS is connected to the first source S1. On the planar device, the potential point x/y changes at a high frequency in potential, and the potential point o changes at a low frequency with the A/B/C alternating-current power in potential or is unchanged in potential.

A switching circuit is provided according to an embodiment of the present disclosure. Here, the planar device is implemented by the planar bidirectional chip as shown in FIG. 17. The switching circuit includes at least one planar device and a filter unit. The filter unit includes at least one capacitor. A first source of each planar device is connected to a first terminal of the filter unit and a terminal of two lines of single-phase alternating-current power. A second source of each planar device is connected to a second terminal of the filter unit and another terminal of the two lines of single-phase alternating-current power.

For example, in a case where a single-phase full-bridge circuit is implemented by the planar device shown in FIG. 17, a corresponding circuit is shown in FIG. 26(a). The single-phase full-bridge circuit includes a first planar device and a second planar device. A potential point y is led out by a half-bridge midpoint of the first planar device. A potential point x is led out by a half-bridge midpoint of the second planar device. The first source S1 of each planar device is connected to the first terminal of the filter unit and a terminal of two lines of single-phase alternating-current power. The second source S2 of each planar device is connected to the second terminal of the filter unit and another terminal of the two lines of single-phase alternating-current power. The filter unit is formed by the first capacitor C1 between the two lines (i.e., the phase line L and the neutral line N) of the single-phase alternating-current power. The base BS of each planar device is connected to the first source S1. In the planar device, the potential point x changes at a high frequency in potential, and the potential point o changes at a low frequency with L/N alternating-current power in potential.

It can be understood that the filter unit may further include two capacitors. For example, the filter unit includes a first capacitor and a second capacitor. In this case, a first terminal of the first capacitor serves as a first terminal of the filter unit, and a first terminal of the second capacitor serves as a second terminal of the filter unit. A second terminal of the first capacitor is connected to a second terminal of the second capacitor.

For example, in a case where the single-phase full-bridge circuit is implemented by the planar device shown in FIG. 17, a corresponding circuit is shown in FIG. 26(b). The circuit includes a first planar device and a second planar device. A potential point y is led out by a half-bridge midpoint of the first planar device. A potential point x is led out by a half-bridge midpoint of the second planar device. The first source S1 of each planar device is connected to the first terminal of the filter unit and another terminal of two lines of single-phase alternating-current power. The second source S2 of each planar device is connected to the second terminal of the filter unit and another terminal of the two lines of single-phase alternating-current power. The filter unit is formed by the first capacitor C1 and the second capacitor C2 between the two lines (i.e., the phase line L and the neutral line N) of the single-phase alternating-current power. The base BS of each planar device is connected to the first source S1. In the planar device, the potential point x changes at a high frequency in potential, and the potential point o changes at a low frequency with L/N alternating-current power in potential or is unchanged in potential.

Those skilled in the art can clearly understand that for the convenience and simplicity of description, the specific working processes of the above-described system, device and unit may be referred to the corresponding processes in the foregoing method embodiments, and are not described in detail here.

In addition, in the description of the embodiments of the present disclosure, unless otherwise clearly defined and limited, the terms "install", "connect" and "link" should be understood in a broad sense. For example, a connection may be a fixed connection, or a detachable connection, or an integral connection; a connection may be a mechanical connection or an electrical connection; and a connection may be a direct connection, or an indirect connection through an intermediate medium, or an internal connection between two elements. For those skilled in the art, specific meanings of the terms in the present disclosure may be understood on a case-by-case basis.

In a case that the functions are implemented in a form of a software functional unit and sold or used as an independent product, the functions may be stored in a computer-readable storage medium. Based on such understanding, part of the technical solutions of the embodiments of the present disclosure which are essential or contribute to the conventional technology, or part of the technical solutions may be embodied in a form of a software product. The computer software product is stored in a storage medium and includes several instructions for causing a computer device (such as a personal computer, a server, or a network device) to perform all or part of the method described in the embodiments of the present disclosure. The storage medium includes a USB disk, a mobile hard drive, a read-only memory (ROM), a random-access memory (RAM), a magnetic disk or optical disk, and other media capable of storing program codes.

In the description of the present disclosure, it should be noted that terms "center", "upper", "lower", "left", "right", "vertical", "horizontal", "inner", "outer", and the like indicate orientations or positional relationships which are based on the drawings. Such terms are only for the convenience of describing the present disclosure and simplifying the description, and do not indicate or imply that the discussed device or element must have a specific orientation or be configured and operated in a specific orientation. Hence, the terms should not be construed as limitations to the present disclosure. Furthermore, the terms "first", "second" and "third" are used for descriptive purposes only and are not to be construed as indicating or implying relative importance.

Finally, it should be noted that the above embodiments are only specific embodiments of the present disclosure, and are used to illustrate the technical solutions of the present disclosure, rather than to limit the present disclosure. The protection scope of the present disclosure is not limited thereto. Although the present disclosure is described in detail with reference to the foregoing embodiments, those skilled in the art should understand that those familiar with the technical field can make modifications or easily envisage changes to the technical solutions recorded in the foregoing embodiments within the technical scope disclosed in the present disclosure, or can obtain equivalent substitutions of some of the technical features. Such modifications, changes or substitutions do not deviate from the essence of the corresponding technical solutions from the spirit and scope of the technical solutions in the embodiments of the present disclosure, and shall be covered by the protection scope of the present disclosure. Therefore, the protection scope of the present disclosure shall be in accordance with the protection scope of the claims.

## Claims

1. A planar device, comprising:
at least one chip; and
a base; wherein
for each of the at least one chip,
the chip comprises a substrate;
the substrate is arranged on a side of the chip close to the base, and the substrate is electrically connected to the base;
a side of the chip away from the base is provided with at least one source and at least one gate;
the at least one source and the at least one gate are electrically connected to the chip; and
the base is connected to a target potential point, and the target potential point is for maintaining a potential of the base in a low-frequency changing state or a constant state.

2. The planar device according to claim 1, wherein
the base is electrically connected to a drain or one of the at least one source, and the drain or the one of the at least one source is the same as the base in potential.

3. The planar device according to claim 1, wherein
the base is a copper base or a direct bond copper ceramic base with copper on one side.

4. The planar device according to claim 1, wherein
the target potential point is a static potential point or a low-frequency potential point.

5. The planar device according to claim 1, wherein
the target potential point is an alternating-current phase voltage potential point, an alternating-current line voltage potential point or a direct-current bus voltage potential point.

6. The planar device according to any one of claims 2 to 5, wherein the at least one chip is a planar single-transistor chip, wherein
a side of the planar single-transistor chip away from the base is provided with one source, one gate, and one drain.

7. The planar device according to any one of claims 2 to 5, wherein the at least one chip is a half-bridge unidirectional chip, and the planar device further comprises a half-bridge midpoint, wherein
a side of the half-bridge unidirectional chip away from the base is provided with a first source, a first drain, a first gate and a second gate; and
the first source, the first drain, the first gate, the second gate and the half-bridge midpoint are connected to the half-bridge unidirectional chip.

8. The planar device according to any one of claims 2 to 5, wherein the at least one chip is a planar bidirectional chip, wherein
a side of the planar bidirectional chip away from the base is provided with a first source, a second source, a first gate, and a second gate; and
the first source, the second source, the first gate and the second gate are connected to the planar bidirectional chip.

9. The planar device according to any one of claims 2 to 5, wherein the at least one chip comprises a first planar bidirectional chip and a second planar bidirectional chip, and the planar device further comprises a half-bridge midpoint, wherein
a side of the first planar bidirectional chip away from the base is provided with a first source, a first gate and a second gate;
a side of the second planar bidirectional chip away from the base is provided with a second source, a third gate, and a fourth gate; and
the first source, the first gate and the second gate are connected to a first side of the first planar bidirectional chip, the second source, the third gate and the fourth gate are connected to a first side of the second planar bidirectional chip, a second side of the first planar bidirectional chip is connected to a second side of the second planar bidirectional chip, and a connection point of the second side of the first planar bidirectional chip and the second side of the second planar bidirectional chip is connected to the half-bridge midpoint.

10. A switching circuit, comprising:
the at least two planar devices according to claim 6; and
a direct-current bus; wherein
the at least two planar devices comprise a first planar device located on an upper transistor of a first bridge arm and a second planar device located on a lower transistor of the first bridge arm;
a drain of the first planar device is connected to a positive electrode of the direct-current bus;
a source of the second planar device is connected to a negative electrode of the direct-current bus; and
a source of the first planar device is connected to a drain of the second planar device.

11. The switching circuit according to claim 10, wherein
the at least two planar devices further comprise a third planar device located on an upper transistor of a second bridge arm and a fourth planar device located on a lower transistor of the second bridge arm;
a drain of the third planar device is connected to the positive electrode of the direct-current bus;
a source of the fourth planar device is connected to the negative electrode of the direct-current bus; and
a source of the third planar device is connected to a drain of the fourth planar device.

12. A switching circuit, comprising:
the at least one planar device according to claim 7; and
a direct-current bus; wherein
a drain of each of the at least one planar device is connected to a positive electrode of the direct-current bus; and
a source of each of the at least one planar device is connected to a negative electrode of the direct-current bus.

13. A switching circuit, comprising:
the at least two planar devices according to claim 8; and
a filter unit, comprising at least one capacitor, wherein
the at least two planar devices comprise a first planar device located on an upper transistor of a first bridge arm and a second planar device located on a lower transistor of the first bridge arm;
a first source of the first planar device is connected to a first terminal of the filter unit and a terminal of two lines of single-phase alternating-current power;
a first source of the second planar device is connected to a second terminal of the filter unit and another terminal of the two lines of the single-phase alternating-current power; and
a second source of the first planar device is connected to a second source of the second planar device.

14. The switching circuit according to claim 13, wherein
the at least two planar devices further comprise a third planar device located on an upper transistor of a second bridge arm and a fourth planar device located on a lower transistor of the second bridge arm;
a first source of the third planar device is connected to the first terminal of the filter unit and a terminal of the two lines of the single-phase alternating-current power;
a first source of the fourth planar device is connected to the second terminal of the filter unit and another terminal of the two lines of the single-phase alternating-current power; and
a second source of the third planar device is connected to a second source of the fourth planar device.

15. A switching circuit, comprising:
the three planar devices according to claim 8;
a first impedance;
a second impedance;
a third impedance;
a first capacitor;
a second capacitor; and
a third capacitor, wherein
the three planar devices comprise a first planar device located on a first bridge arm, a second planar device located on a second bridge arm and a third planar device located on a third bridge arm;
a first alternating-current phase line is connected to a second source of the first planar device and a first terminal of the first capacitor through the first impedance;
a second alternating-current phase line is connected to a second source of the second planar device and a first terminal of the second capacitor through the second impedance;
a third alternating-current phase line is connected to a second source of the third planar device and a first terminal of the third capacitor through the third impedance;
a first source of the first planar device, a first source of the second planar device, and a first source of the third planar device are connected to each other; and
a second terminal of the first capacitor, a second terminal of the second capacitor, and a second terminal of the third capacitor are connected to each other.

16. A switching circuit, comprising:
the six planar devices according to claim 8;
a first impedance;
a second impedance;
a third impedance;
a first capacitor;
a second capacitor; and
a third capacitor, wherein
the six planar devices comprise a first planar device located on an upper transistor of a first bridge arm, a second planar device located on an upper transistor of a second bridge arm, a third planar device located on an upper transistor of a third bridge arm, a fourth planar device located on a lower transistor of the first bridge arm, a fifth planar device located on a lower transistor of the second bridge arm, and a sixth planar device located on a lower transistor of the third bridge arm;
a first alternating-current phase line is connected to a second source of the fourth planar device and a second source of the first planar device through the first impedance;
a second alternating-current phase line is connected to a second source of the fifth planar device and a second source of the second planar device through the second impedance;
a third alternating-current phase line is connected to a second source of the sixth planar device and a second source of the third planar device through the third impedance;
a first source of the first planar device, a first source of the second planar device, and a first source of the third planar device are connected to each other;
a first source of the fourth planar device, a first source of the fifth planar device, and a first source of the sixth planar device are connected to each other; and
a first terminal of the first capacitor is connected to the first alternating-current phase line, a first terminal of the second capacitor is connected to the second alternating-current phase line, and a first terminal of the third capacitor is connected to the third alternating-current phase line; and a second terminal of the first capacitor, a second terminal of the second capacitor and a second terminal of the third capacitor are connected to each other.

17. A switching circuit, comprising:
the at least one planar device according to claim 9; and
a filter capacitor, comprising at least one capacitor, wherein
a first source of each of the at least one planar device is connected to a first terminal of the filter unit and a terminal of two lines of single-phase alternating-current power; and
a second source of each of the at least one planar device is connected to a second terminal of the filter unit and another terminal of the two lines of the single-phase alternating-current power.
